(19) **Europäisches Patentamt** / **European Patent Office** / **Office européen des brevets**

(11) **EP 3 004 431 B1**

(12) **FASCICULE DE BREVET EUROPEEN**

(45) Date de publication et mention de la délivrance du brevet:
**22.08.2018 Bulletin 2018/34**

(21) Numéro de dépôt: **14729451.6**

(22) Date de dépôt: **26.05.2014**

(51) Int Cl.:
**C30B 11/14** (2006.01)   **C30B 29/06** (2006.01)
**B28D 5/04** (2006.01)

(86) Numéro de dépôt international:
**PCT/IB2014/061724**

(87) Numéro de publication internationale:
**WO 2014/191900 (04.12.2014 Gazette 2014/49)**

(54) **PROCEDE DE FABRICATION D'UN LINGOT DE SILICIUM DOTE DE JOINTS DE GRAINS SYMETRIQUES**

VERFAHREN ZUR HERSTELLUNG EINES SILICIUMBLOCKS MIT SYMMETRISCHEN KORNGRENZEN

METHOD FOR PRODUCING A SILICON INGOT PROVIDED WITH SYMMETRICAL GRAIN BOUNDARIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2013 FR 1354761**

(43) Date de publication de la demande:
**13.04.2016 Bulletin 2016/15**

(73) Titulaire: **Commissariat à l'Energie Atomique et aux Energies Alternatives**
**75015 Paris (FR)**

(72) Inventeurs:
• **FORTIN, Gautier**
  **F-73190 Saint-Baldoph (FR)**
• **AMARAL DE OLIVEIRA, Vanessa**
  **88040-440 Carvoeira, Florianópolis/SC (BR)**
• **CAMEL, Denis**
  **F-73000 Chambéry (FR)**
• **PIHAN, Etienne**
  **F-73290 La Motte Servolex (FR)**

(74) Mandataire: **Nony**
**11 rue Saint-Georges**
**75009 Paris (FR)**

(56) Documents cités:
CN-A- 102 747 417       DE-A1-102011 086 669
DE-A1-102012 102 597    US-A1- 2009 047 203
US-A1- 2013 233 239

• **TAKAHASHI I ET AL: "Generation mechanism of dislocations during directional solidification of multicrystalline silicon using artificially designed seed", JOURNAL OF CRYSTAL GROWTH, ELSEVIER, AMSTERDAM, NL, vol. 312, no. 7, 15 mars 2010 (2010-03-15), pages 897-901, XP026929260, ISSN: 0022-0248, DOI: 10.1016/J.JCRYSGRO.2010.01.011 [extrait le 2010-01-18]**
• **KUTSUKAKE KENTARO ET AL: "Influence of structural imperfection of[Sigma]5 grain boundaries in bulk multicrystalline Si on their electrical activities", JOURNAL OF APPLIED PHYSICS, AMERICAN INSTITUTE OF PHYSICS. NEW YORK, US, vol. 101, no. 6, 19 mars 2007 (2007-03-19), pages 63509-063509, XP012098025, ISSN: 0021-8979, DOI: 10.1063/1.2710348**

Remarques:
Le dossier contient des informations techniques présentées postérieurement au dépôt de la demande et ne figurant pas dans le présent fascicule.

EP 3 004 431 B1

Printed by Jouve, 75001 PARIS (FR)

**Description**

La présente invention se rapporte à un nouveau procédé de fabrication d'un lingot de silicium, doté de joints de grains symétriques. En particulier, un tel lingot peut être avantageusement dédié à donner, par découpe, des plaquettes de silicium monocristallin dénué de joints de grains.

De telles plaquettes sont particulièrement avantageuses dans le cadre de l'élaboration de cellules et modules photovoltaïques.

Actuellement, les cellules photovoltaïques sont majoritairement fabriquées à partir de silicium mono ou multi-cristallin. La filière de production de silicium cristallin la plus courante met en jeu la solidification de lingots à partir d'un bain de silicium liquide. Ces lingots sont ensuite découpés en plaquettes qui peuvent être transformées en cellules photovoltaïques.

Les lingots de silicium multicristallin sont classiquement réalisés par fusion d'une charge de silicium, suivie d'une solidification directionnelle. Cette technique permet avantageusement de cristalliser de grands volumes de silicium ; et la taille des lingots usinés peut être ajustée en variant la dimension des creusets.

Malheureusement, ce procédé très productif présente un inconvénient majeur au regard de la structure cristalline des lingots de silicium ainsi réalisés. De fait, cette technique conduit à des lingots présentant une structure cristalline caractérisée par un nombre très important de grains et d'orientations cristallines différentes, mais également par une densité de dislocations élevée, ces dislocations étant réparties de manière inhomogène dans le lingot. Par conséquent, ce procédé n'est pas efficace pour obtenir un lingot de silicium quasi-monocristallin, dit « *mono-like* », c'est-à-dire constitué très majoritairement (notamment à plus de 90 %) de matériau monocristallin.

Depuis quelques années, des techniques ont été développées pour élaborer des lingots de silicium mono-like par solidification directionnelle avec des structures cristallines améliorées, notamment *via* un meilleur contrôle de la germination, comme décrit dans le document Fujiwara et al., Growth of structure-controlled polycrystalline silicon ingots for solar cells by casting, Acta Materialia, 54 (2006), 3191-3197, ou encore *via* l'utilisation de germes monocristallins couvrant le fond du moule de solidification, comme proposé dans les documents WO 2007/084934, US 2010/0192838,

US 2010/0193989, US 2010/0193664, WO 2009/014963, US 2010/0197070 et US 2013/0095028.

DE 10 2011 086669 A1 décrit un procédé de solidification dirigée d'un lingot de silicium au moyen d'un pavage de germes présentant des orientations différentes les uns des autres. En particulier ce document enseigne de disposer les germes selon un pavage de type échiquier avec une éventuelle symétrie de rotation autour d'un axe cristallographique. Ce document est considéré comme divulguant l'objet du préambule de la revendication 1. Toutefois, l'utilisation de germes monocristallins n'est pas suffisante pour que la croissance soit exempte de défauts. En effet, pour réaliser un lingot mono-like adapté à des tailles de creuset industrielles, il est nécessaire d'ajouter au fond du creuset plusieurs germes. Malheureusement, les germes, ainsi positionnés les uns à côté des autres en fond de creuset créent, suivant leurs dimensions et leurs désorientations respectives, de nombreux joints de germes, sources de défauts dans les lingots mono-like. En effet, les joints de germes présents au niveau du pavage en fond de creuset sont à l'origine de la formation de joints de grains, qui peuvent ne pas être parallèles à la direction de cristallisation, et au voisinage desquels peuvent se développer des dislocations et sous-joints dans le lingot mono-like obtenu par solidification dirigée par reprise sur germes.

Ainsi, la propagation des joints de grains à partir de la position initiale des joints de germes dans le lingot de silicium n'est nullement maitrisée. Ces défauts cristallins peuvent donc être situés à divers endroits dans le lingot mono-like formé, et donc dans les plaquettes de silicium résultantes de la découpe en briques de ce lingot.

De plus, les dislocations et sous-joints accumulés autour de ces joints diminuent les caractéristiques photovoltaïques (courant, facteur de forme, tension) des cellules réalisées avec des matériaux les contenant et, par conséquent, peuvent s'avérer particulièrement préjudiciables au regard du rendement de la cellule photovoltaïque qui sera formée à partir d'une telle plaquette.

Par conséquent, il demeure un besoin de disposer d'une méthode d'élaboration d'un lingot de silicium mono-like, permettant de palier les inconvénients précités.

La présente invention vise précisément à répondre à ce besoin.

Plus particulièrement, elle propose un nouveau procédé pour former un lingot de silicium mono-like, permettant de maitriser la propagation des joints de grains sur toute la hauteur du lingot.

La présente invention concerne ainsi, selon un premier de ses aspects, un procédé selon la revendication 1.

On entend par « retournement d'axe (T) », encore appelée symétrie orthogonale d'axe (T), une rotation de 180° autour de l'axe (T).

Autrement dit, deux germes contigus d'un pavage selon l'invention, notés germe A et germe B, sont tels que le germe B est obtenu à partir d'un germe A ayant subi une rotation d'un angle de 180° autour de l'un des vecteurs perpendiculaires aux faces latérales du germe, c'est-à-dire dans le cadre d'un pavage sous forme d'un quadrillage, autour de l'axe (x) ou (y).

Comme détaillé dans la suite du texte, l'invention permet avantageusement de garantir la symétrie des réseaux cristallins de deux germes A et B contigus, par rapport au plan P défini par la frontière entre lesdits germes, sans nécessiter de recourir à des mesures d'orientation cristallographique.

Dans la suite du texte, et sauf indication contraire, un germe et/ou lingot et/ou wafer, définis par la suite, sont caractérisés pour le référentiel orthogonal d'axes (x), (y) et (z), correspondant aux trois directions principales, respectivement du germe, du lingot ou du wafer. De préférence, l'axe (z) d'un germe et/ou d'un lingot est colinéaire à l'axe (Z) longitudinal du creuset. Dans le cas d'un pavage de type quadrillage, les directions (x) et (y) correspondent aussi aux directions parallèles aux lignes du quadrillage, encore appelées par la suite « directions de pavage ».

L'axe longitudinal du creuset désigne la ligne joignant l'ensemble des barycentres des sections transversales dudit creuset (parois du creuset inclus). L'axe longitudinal peut être plus particulièrement un axe de symétrie pour le creuset.

Par « joint de grains symétrique », on entend désigner un joint de grains plan, présent dans le lingot de silicium formé à l'issue de la solidification dirigée du silicium, et définissant un plan de symétrie cristalline pour les réseaux cristallins situés de part et d'autre de ce plan. De préférence, le plan d'un joint de grains symétrique comporte un axe colinéaire à l'axe (Z) du creuset.

On entend bien entendu par « forme prisme droit », une forme approximativement de type prisme de droit. En particulier, les germes du pavage en fond de creuset présentent des parois latérales verticales ou sensiblement verticales (déviation de ± 5°). Par ailleurs, les surfaces des germes sont approximativement planes, aux irrégularités de surface près.

On désignera dans la suite du texte, comme étant la « base du germe », la surface globalement plane du germe en regard du fond du creuset.

Comme détaillé par la suite, la base des germes est de forme carrée ou rectangulaire, les germes étant alors approximativement de forme pavé droit.

Selon un autre de ses aspects, la présente invention concerne un lingot de silicium doté de joints de grains symétriques obtenu selon un tel procédé.

Comme illustré dans l'exemple qui suit, la position des joints de grains étant ainsi maîtrisée lors de la fabrication du lingot selon le procédé de l'invention, il est possible d'éliminer, selon une variante de réalisation, lors de la découpe du lingot en briques, ces joints de grains. Ainsi, les plaquettes de silicium, plus généralement appelées « wafers », formées à partir de ces briques, sont avantageusement dénuées de joints de grains.

Ainsi, selon encore un autre de ses aspects, la présente invention concerne un procédé de fabrication de plaquettes de silicium monocristallin et dénué de joints de grains, comprenant une étape de découpe d'un lingot de silicium tel que défini précédemment, en briques, le long des plans P.

D'autres caractéristiques, avantages et modes d'application du procédé, du lingot de silicium et plaquettes obtenues selon l'invention, ressortiront mieux à la lecture de la description détaillée qui va suivre, de l'exemple de réalisation de l'invention et à l'examen des dessins annexés, sur lesquels :

- la figure 1 représente, de manière schématique et partielle, en coupe transversale, les différentes étapes d'un procédé de fabrication d'un lingot et de plaquettes de silicium selon l'invention ;
- la figure 2 représente, en vue 3D, un germe de silicium de forme pavé droit à base carrée ;
- la figure 3 représente, en vue 3D, la découpe d'un lingot Cz en germes monocristallins (2) présentant une désorientation du réseau cristallin autour de l'axe ($Z_c$) ;
- la figure 4 représente, en vue 3D, la formation des germes contigus par rotation d'un angle de 180° (ou retournement) autour de l'axe (y) ou de l'axe (x) ;
- la figure 5 représente, en vue de dessus, un pavage en fond de creuset « Gen5 », conforme à l'invention, à l'aide des germes A et B ;
- la figure 6 représente, de manière schématique, l'évolution d'un joint de grain symétrique (6) et d'un joint de grain non symétrique (7), sur la hauteur d'un lingot, à partir de germes présentant différentes orientations cristallines (figure 6a) ; et la découpe du lingot (figure 6b) ;
- la figure 7 représente, en vue 3D, le briquetage d'un lingot type Gen5 selon les plans P ($P_1$, $P_2$, $P_3$, ...) ;
- la figure 8 représente une figure de pôle (001) d'une plaquette découpée dans un lingot obtenu par un procédé selon l'invention et comportant quatre grains, deux grains contigus présentant une relation de symétrie cristalline par rapport au joint de grain qui les sépare.

Il convient de noter que, pour des raisons de clarté, les différents éléments sur les figures sont représentés en échelle libre, les dimensions réelles des différentes parties n'étant pas respectées.

Dans la suite du texte, les expressions « compris entre... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

**ETAPE (i) : PAVAGE EN FOND DE CREUSET**

Comme précisé précédemment, le procédé de l'invention met en oeuvre un pavage en fond du creuset par des germes (2) de silicium monocristallin.

Selon un mode de réalisation particulier, le pavage est formé au fond d'un creuset classique. On peut encore envisager des creusets dont le fond lui-même est formé du pavage de germes.

De préférence, les germes pavent la totalité de la surface du fond du creuset (par exemple, dans le cas d'un creuset en graphite) ou la quasi-totalité de la surface du fond du creuset (par exemple, dans le cas d'un creuset qui peut être sujet à un retrait, par exemple de 2 %, tel que les creusets en silice, il subsiste une surface au fond du creuset non couverte par les germes).

Selon un mode de réalisation particulier, la plus petite dimension des germes de silicium dans le plan de pavage est supérieure ou égale à 95 mm. En particulier, dans le cas d'un pavage sous la forme d'un quadrillage, la plus petite dimension d'un germe de silicium selon l'une des directions (x) et (y) est supérieure ou égale à 95 mm.

Comme vu précédemment, les germes sont de forme pavé droit, de base carrée ou rectangulaire. De tels germes permettent avantageusement un pavage en fond du creuset sous la forme d'un quadrillage divisé en carrés ou en rectangles. Comme détaillé dans la suite du texte, un tel pavage permet de simplifier le briquetage du lingot formé à l'issue du procédé de l'invention.

La figure la représente, en vue de coupe, un creuset (1) dont le fond est tapissé d'un pavage de germes (2) conforme à l'invention.

Bien entendu, il appartient à l'homme du métier d'ajuster le nombre de germes formant le pavage en fond de creuset, et leur dimension, au regard de la dimension du creuset utilisé, et en prenant en considération la dimension des briques et plaquettes de silicium souhaitées, le diamètre du fil de découpe qui sera utilisé, le cas échéant, pour la découpe du lingot en briques, etc..

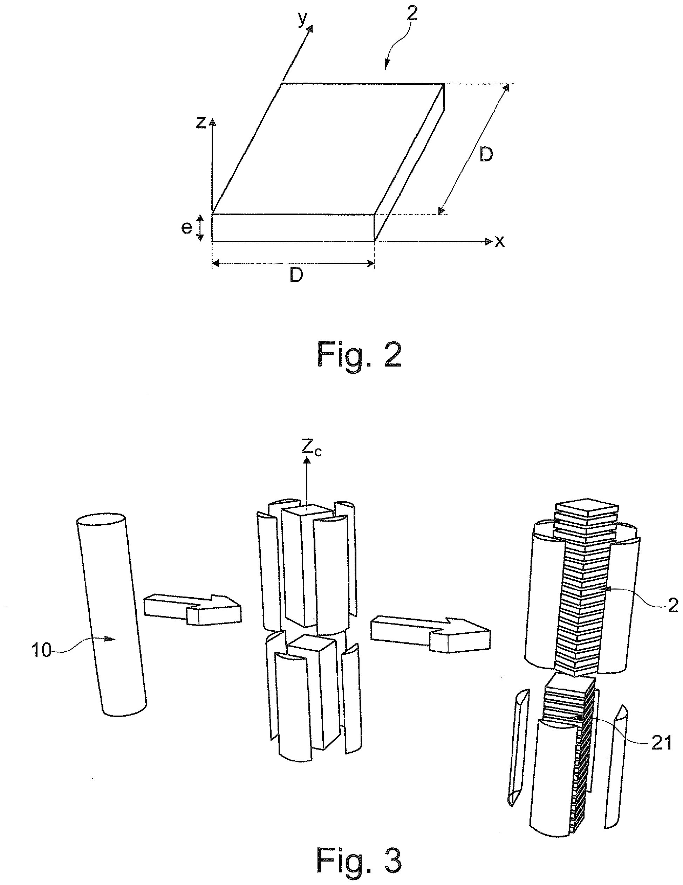

Selon une première variante de réalisation, le pavage est réalisé à l'aide de germes de forme pavé droit à base carrée, comme représenté en figure 2, en particulier de côté (D) d'un carré supérieur ou égal à 95 mm. Tel qu'illustré sur la figure 2, un germe est défini par trois axes (x), (y), (z), définis par les arrêtes du germe, l'axe (z) étant colinéaire à l'axe (Z) du creuset.

A titre d'exemple, pour la réalisation de wafers de dimension classique 156 x 156 mm, les germes peuvent être de dimension de base carrée de l'ordre de 157 x 157 mm, comme illustré dans l'exemple 1.

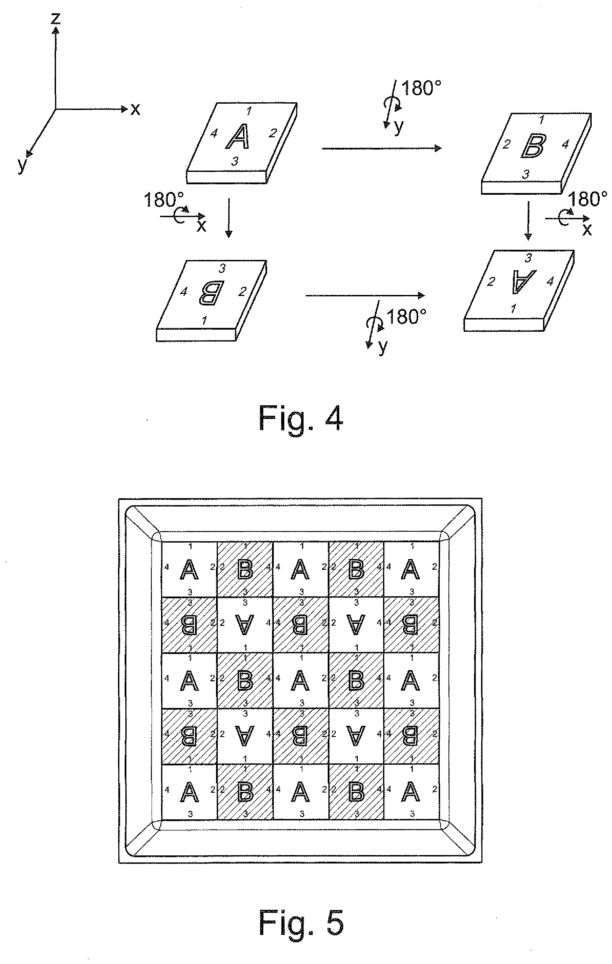

Un tel pavage régulier du fond du creuset à l'aide de 5 x 5 germes à base carrée est par exemple représenté en vue de dessus en figure 5.

Selon une seconde variante de réalisation, le pavage est réalisé à l'aide de germes de forme pavé droit à base rectangulaire, en particulier de largeur supérieure ou égale à 95 mm et de longueur supérieure ou égale à deux fois la largeur.

De préférence, l'ensemble des germes formant le pavage en fond de creuset présente la même épaisseur (e) suivant l'axe (Z).

L'homme du métier est à même d'ajuster l'épaisseur (e) des germes mis en oeuvre, au regard notamment de la hauteur du lingot souhaité et de la forme du front de solidification du four utilisé.

D'une manière générale, l'épaisseur (e) est supérieure ou égale à 5 mm. A titre d'exemple, elle peut être d'environ 25 mm.

Comme évoqué précédemment, deux germes A et B contigus dans un pavage réalisé selon le procédé de l'invention, comme représenté schématiquement en figure 5, sont d'orientations cristallines distinctes, plus particulièrement d'orientations cristallines distinctes selon les axes (x) et/ou (y).

Chaque germe A présente un réseau cristallin symétrique du réseau cristallin d'un germe B contigu, par rapport au plan P défini par la frontière (3) entre lesdits germes A et B, comme représenté schématiquement en figure la.

La différence d'orientation entre les réseaux cristallins des germes A et B est appelée « désorientation totale ». Cette désorientation totale se traduit par une opération de rotation autour d'un axe de désorientation <u v w> et d'un angle de désorientation 2θ. Par la suite, on nommera « désorientation totale », l'angle de désorientation 2θ le plus petit parmi toutes les opérations de rotation précitées ; et on nommera « axe de désorientation », l'axe associé à cet angle.

De préférence, la désorientation totale 2θ entre le réseau cristallin du germe A et le réseau cristallin du germe B contigu est supérieure ou égale à 5°, et plus particulièrement comprise entre 6° et 45°.

Selon un mode de réalisation particulièrement préféré, les réseaux cristallins des germes A et B présentent tous deux une direction colinéaire à l'axe (Z), de préférence une direction <100> (ou proche de <100>), colinéaire à l'axe (Z), chacun des germes étant avantageusement désorienté selon un même angle θ par rapport à cette direction selon (x) et/ou (y).

La désorientation θ d'un germe peut être déterminée par des méthodes de mesure connues de l'homme du métier, par exemple par mesure des angles avec la méthode de Laue, par diffraction de rayon X ou encore par diffraction des électrons rétrodiffusés (EBSD pour « Electron BackScattered Diffraction » en langue anglaise).

Selon un mode de réalisation préféré, la désorientation entre les réseaux cristallins des germes A et B s'effectue autour d'un axe <001>. De préférence, l'axe <001> est confondu avec l'axe (Z) du creuset et/ou avec l'axe (z) du germe.

Un tel mode de réalisation s'avère particulièrement avantageux, au regard des plaquettes qui seront formées par découpe du lingot obtenu à partir d'un tel pavage de germes selon le procédé de l'invention.

De fait, les surfaces des wafers issus de la découpe des briques perpendiculairement à la surface du lingot, suivant les plans de joints de grains verticaux, comme décrit plus précisément dans la suite du texte, sont, aux irrégularités de découpe près, sensiblement parallèles aux plans (001). Etant d'orientation (001), les surfaces des wafers ainsi formés présentent la caractéristique d'être efficacement texturisées par une texturation basique (à base de KOH ou NaOH par exemple). Il peut en résulter un gain de réflectivité d'environ 5 à 12 % relatif en face, comparativement à des texturations basiques sur d'autres orientations ou à des texturations acides sur une orientation quelconque.

De manière avantageuse, comme évoqué précédemment, il est possible de s'affranchir de la mesure des angles de désorientation θ de chacun des germes mis en oeuvre, en réalisant de manière aisée le pavage selon l'invention à partir d'un seul type de germes.

Ainsi, selon un mode de réalisation particulier, le pavage en fond du creuset est réalisé à partir de germes de silicium identiques, le germe B étant obtenu à partir d'un germe A ayant subi une rotation d'un angle de 180° autour de l'un des vecteurs perpendiculaires aux faces latérales du germes, c'est-à-dire dans le cadre d'un pavage sous forme d'un quadrillage, autour de l'axe (x) ou (y).

A titre d'exemple, la figure 4 représente l'obtention, dans le cadre d'un pavage de type quadrillage, de deux germes contigus dans la direction (x) et deux germes contigus dans la direction (y). Par exemple, pour la réalisation des germes A et B de type pavé droit contigus suivant la direction (x), le germe B est obtenu à partir d'un germe A par rotation d'un angle de 180° (ou retournement) autour de l'axe (y).

Ainsi, pour la réalisation du pavage selon la direction (x) (respectivement la direction (y)) avec des germes A et B disposés de manière jointive et alternée, un germe B est obtenu à partir d'un germe A par retournement d'axe (y) (respectivement retournement d'axe (x)).

Avantageusement, il est ainsi possible de former un pavage de germes conforme à l'invention à partir de germes identiques, en réalisant de simples opérations de retournement respectant les conditions décrites ci-dessus.

En particulier, un tel mode de réalisation permet de s'affranchir de mesures d'orientation cristallographique pour garantir que deux germes contigus du pavage présentent bien des réseaux cristallins symétriques. De telles mesures d'orientation cristallographiques étant complexes à réaliser, la préparation d'un pavage de germes selon cette variante s'en trouve simplifiée. Notamment, le temps de préparation du pavage en fond de creuset peut ainsi être réduit.

Les germes (2) de silicium mono-cristallin peuvent être par exemple issus d'un lingot de silicium élaboré selon une technique de tirage Czochralski (encore appelé lingot « Cz »), technique dans laquelle un germe mono-cristallin de silicium est mis en contact avec un bain de silicium en fusion, afin de faire croître un lingot monocristallin.

Cette méthode fournit généralement des lingots Cz de forme cylindrique. Ils peuvent être usinés, de manière conventionnelle, comme représenté schématiquement en figure 3, et découpé en tranches perpendiculaires à l'axe ($Z_c$) du cylindre pour obtenir des germes de forme pavé droit.

Le tirage donne un lingot de silicium avec un plan cristallographique perpendiculaire à l'axe ($Z_c$) du lingot et déterminé par l'orientation cristalline du germe (par exemple <100>).

Il est alors possible d'usiner des germes (2) avec la désorientation θ du réseau cristallin souhaitée, par découpe du lingot Cz avec une rotation autour de l'axe du cylindre ($Z_c$), comme représenté schématiquement en figure 3.

Par exemple, sur la figure 3, le cristal d'un germe (21) (qui possède un cubage imaginaire et parfait des faces (i, j, k) représentant les plans perpendiculaires aux directions <100> du lingot Cz usiné) ne possède aucune désorientation par rapport aux axes (x), (y) et (z) du germe, à la différence du germe (2) usiné avec une désorientation cristalline θ autour de l'axe ($Z_c$) de plusieurs degrés. Pour un tel germe (2), le cristal de silicium est désorienté d'un angle θ non nul autour de l'axe ($Z_c$) par rapport aux axes (x) et (y) du germe, l'axe (z) étant colinéaire à l'axe ($Z_c$).

Un autre germe (2) réalisé dans les mêmes conditions pourra ensuite être utilisé afin d'être retourné, comme représenté en figure 4, et former un germe de type B, contigu au germe A, ce qui permet d'obtenir une désorientation totale 2θ entre les réseaux cristallins des germes contigus A et B.

Selon une autre variante de réalisation, les germes (2) de silicium proviennent du recyclage d'un lingot élaboré lors d'une précédente solidification dirigée selon le procédé de l'invention. Plus particulièrement, les germes peuvent être issus du prélèvement, partiel ou total, d'une tranche horizontale, ou du prélèvement partiel d'une tranche verticale, d'un lingot de silicium formé selon le procédé de l'invention.

## ETAPE (ii) : FORMATION DU LINGOT DE SILICIUM

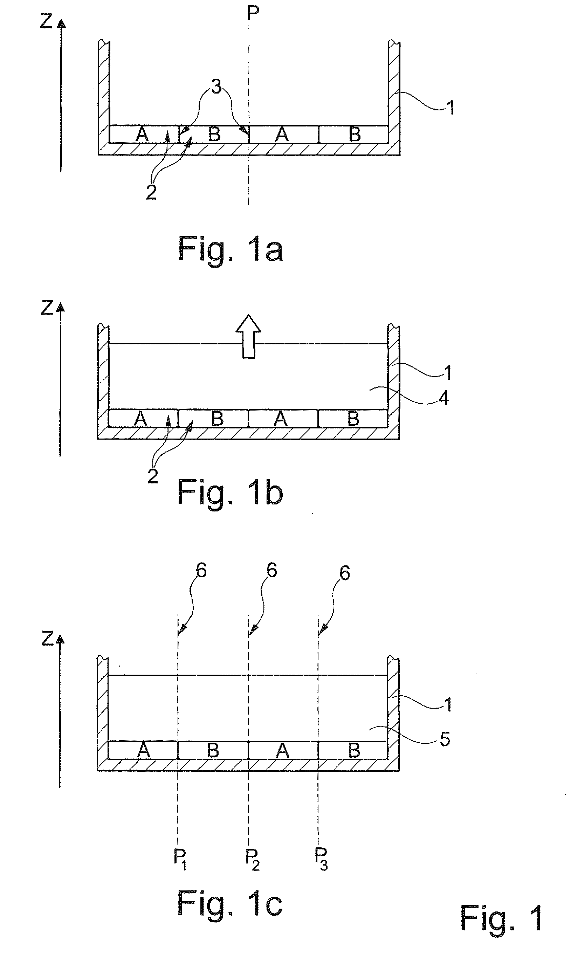

Dans une seconde étape du procédé de l'invention, on procède à la solidification dirigée de silicium par reprise sur germes selon une direction de croissance colinéaire à l'axe (Z), comme représenté schématiquement en figure 1b.

L'homme du métier est à même d'ajuster les conditions opératoires pour l'élaboration du lingot de silicium par solidification dirigée.

Celle-ci peut être opérée dans un four conventionnel de solidification dirigée, comme par exemple dans un four de cristallisation de type HEM (provenant du nom anglais « Heat Exchange Method ») ou de type Bridgman avec un chauffage fixe par le haut et les côtés, qui permet de cristalliser la charge de silicium avec un gradient de température contrôlé.

D'une manière générale, la solidification dirigée est effectuée en faisant fondre, dans un premier temps, une charge de silicium dans le creuset préparé en étape (i). Lorsque le silicium est complètement en fusion, et que les germes commencent à fondre, le silicium en fusion (4) est solidifié, de façon dirigée, à faible vitesse (typiquement de 5 à 30 mm/h).

La solidification dirigée peut être réalisée par déplacement du système de chauffage et/ou par refroidissement contrôlé, permettant un déplacement progressif du front de solidification (front de séparation entre la phase solide et la phase liquide) vers le haut du creuset, comme représenté schématiquement en figure 1b.

Le lingot (5) obtenu à l'issue de la solidification dirigé peut être ensuite refroidi, notamment jusqu'à température ambiante (20°C $\pm$ 5°C).

Selon un mode de réalisation particulier, le lingot (5) formé par solidification dirigée peut présenter une hauteur, mesurée suivant l'axe (Z) de croissance, supérieure ou égale à 100 mm, en particulier allant de 180 à 800 mm.

De manière avantageuse, comme représenté schématiquement en figure 1c, les joints de grains se propagent dans le lingot de silicium de manière contrôlée à partir des joints de germes, suivant les plans $P_1$, $P_2$, $P_3$,... définis par les frontières (3) entres chacun des germes A et B contigus de réseaux cristallins symétriques, et perpendiculairement à la surface des germes.

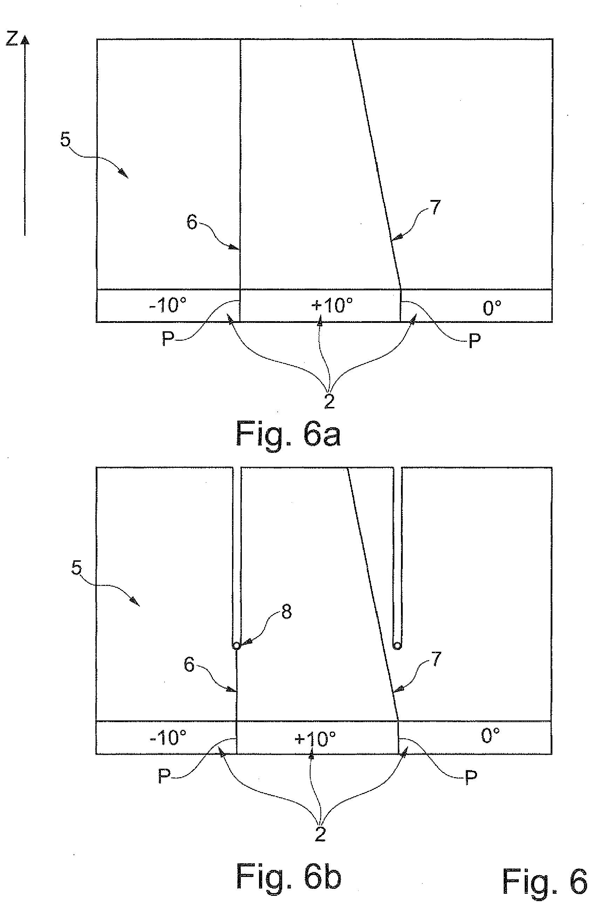

A titre d'exemple schématique, la figure 6a représente un joint de grains (6) symétrique formé dans le lingot de silicium (5) à partir de deux germes (2) contigus conformes à l'invention, présentant des réseaux cristallins symétriques l'un de l'autre (germes accolés « +10° » et « -10° », désorientation totale de 20° suivant l'axe (Z)), par rapport au plan P défini par la frontière (3) entre les germes.

## PLAQUETTES DE SILICIUM

Comme évoqué précédemment, le procédé de l'invention permet avantageusement de contrôler la propagation des joints de grains dans le lingot formé.

Selon un mode de réalisation particulier, tout ou partie des joints de grains symétriques peuvent être utilisés à réaliser un marquage identifiant ou esthétique. Un tel marquage peut être par exemple utile pour identifier les cellules comportant des joints de grains symétriques, marquer l'identité du producteur de lingots ou wafers, ou aider à la traçabilité dans le processus.

Après éboutage standard des zones périphériques du lingot, ce dernier peut être découpé en briques.

Selon une première variante de réalisation, la découpe du lingot peut être opérée indépendamment de la position des plans de joints P ($P_1$, $P_2$, $P_3$, ...) définis par les frontières entre les germes (2) du pavage en fond de creuset. Les briques résultantes contiennent ainsi des joints de grains symétriques.

Selon une seconde variante de réalisation, comme représenté schématiquement en figure 1c, la découpe peut être opérée le long des plans P ($P_1$, $P_2$, $P_3$, ....), définis par les frontières entre les germes (2) du pavage en fond de creuset.

Les joints de grains étant présents dans le lingot formé selon le procédé de l'invention suivant les plans P, la découpe du lingot de silicium le long de ces plans, permet ainsi d'éliminer les joints de grains et d'obtenir avantageusement des briques dénuées de joints de grains.

Les positions de découpe du lingot sont aisément identifiables sur le lingot dans la mesure où elles se situent au niveau des frontières entre les germes tapissant le fond du creuset.

L'homme du métier est à même d'ajuster les moyens conventionnels de découpe des lingots de silicium en briques, pour obtenir une découpe efficace du lingot le long des plans P de joints de grains.

La découpe peut être opérée à l'aide d'un fil de découpe ou encore d'une scie à bande.

A titre d'exemple, la figure 6b représente, de manière schématique, la découpe du lingot (5) le long du joint de grains symétrique (6), à l'aide d'un fil de découpe (8).

Pour un lingot élaboré à partir d'un pavage de germes de type quadrillage, la découpe peut être par exemple opérée à l'aide d'une machine conventionnelle de type Squarer, ou scie à bande.

Il appartient à l'homme du métier d'adapter le pas du guide-fils, au regard de la dimension des germes de pavage mis en oeuvre et du diamètre des fils de découpe utilisés, de manière à ce que la découpe à l'aide du Squarer se fasse le long de chacun des plans P et permette d'éliminer les joints de grains symétriques du lingot.

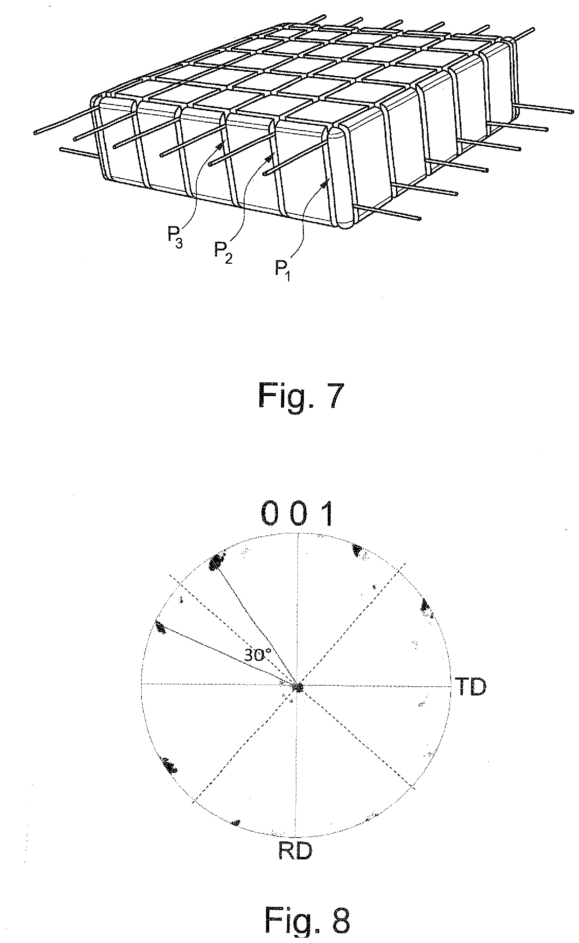

Une telle découpe est représentée schématiquement en figure 7.

Les plaquettes de silicium peuvent être ensuite élaborées à partir de ces briques, selon des techniques classiques connues de l'homme du métier, notamment par découpe des briques, rectification des faces, éboutages des extrémités haute et basse pour ajuster les dimensions de la plaquette etc.

Ces plaquettes de très haute qualité cristalline, dotées de joints de grains symétriques ou totalement dénuées de joint de grains selon la variante de découpe mise en oeuvre, peuvent être avantageusement utilisées pour l'élaboration de cellules photovoltaïques, par exemple pour les filières homojonction ou hétérojonction.

L'invention va maintenant être décrite au moyen des exemples suivants donnés bien entendu à titre illustratif et non limitatif de l'invention.

EXEMPLES

**EXEMPLE 1**

*(i) Préparation des germes*

Les germes de première utilisation sont issus de lingots Cz. Le lingot Cz choisi possède un diamètre de 9 pouces (228,6 mm) et une orientation suivant Z <100> (à $\pm$ 0,5° près).

Sachant que l'on souhaite réaliser des cellules possédant une surface de 156 ($\pm$0,5) x 156 ($\pm$0,5) mm$^2$, la dimension des germes sera :

$$D_{germe} = D_{brique\ avant\ rectification} + E_{fils} = 156,7 + 0,6 = 157,3\ mm$$

Le lingot Cz est ainsi usiné en germes de surface 157,3 x 157,3 mm$^2$ et d'épaisseur de 20 mm. La découpe est réalisée avec une rotation autour de l'axe Z par rapport à une position référence de cubage 3 faces <100>, pour introduire une désorientation θ du réseau cristallin des germes, comme représenté schématiquement en figure 3.

Les germes prélevés sont placés au fond de creuset avec un pavage tel que représenté en figure 5, alternant un germe A, prélevé tel quel du lingot Cz, et un germe B, qui a subi par rapport au germe A, une rotation de 180° autour de l'axe (x) ou (y) comme représenté en figure 4, ce qui permet d'obtenir une désorientation totale 2θ et donc la symétrie désirée entre les germes A et B.

*(ii) Croissance directionnelle du silicium par reprise sur germes*

Le four de cristallisation utilisé pour la cristallisation par reprise sur germes est un four de taille « Gen 5 » (370 à 700 kg de charge) possédant trois zones de chauffe pilotées en température ou en puissance : une zone de chauffe haute, une zone de chauffe basse et une zone de chauffe latérale.

Un lingot de silicium est formé dans le creuset par la succession des étapes suivantes :

- fusion dirigée de la charge de silicium et fusion partielle des germes ;
- croissance par solidification dirigée ; et
- refroidissement du lingot.

*(iii) Découpe du lingot*

Le lingot obtenu est ensuite découpé en briques dans un « *squarer* » avec un pas de guide-fils de 157,3 mm et une épaisseur de découpe de 600 $\mu$m par trait de découpe. Les briques résultantes ont une section de 156,7 x 156.7 mm$^2$ avant rectification et 156 x 156 mm$^2$ après 350 $\mu$m de rectification par face.

Les plaquettes découpées dans de telles briques sont exemptes de joints de grains issus des joints de germes.

**EXEMPLE 2**

*(i) Préparation des germes*

Les germes de première utilisation sont issus d'un lingot Cz. Le lingot Cz choisi possède un diamètre de 9 pouces (228,6 mm) et une orientation suivant Z <100> (à $\pm$ 0,5° près).

Le lingot Cz est usiné en germes de section 157,3 x 157,3 mm$^2$. La découpe est réalisée avec une rotation autour de l'axe Z par rapport à une position référence de cubage 3 faces <100>, pour introduire une désorientation θ égale à 15° du réseau cristallin des germes, comme représenté schématiquement en figure 3.

Un premier pavage de quatre germes est réalisé, selon la méthode illustrée en figure 4. Un premier germe, prélevé du lingot Cz, est positionné au fond du creuset. On sélectionne ensuite un germe du même lingot Cz, qui présente la même orientation que le premier germe et peut donc être considéré comme identique au premier germe, et on lui fait subir une rotation de 180° autour de l'axe (y) du quadrillage. Le germe ainsi retourné, dit second germe, est disposé de manière jointive et contigüe au premier germe le long de l'axe (x) du quadrillage. De cette façon, les premier et deuxième germes ainsi positionnés présentent des réseaux cristallins symétriques et une désorientation totale 2θ de 30°.

On sélectionne ensuite un germe du même lingot Cz qui présente la même orientation cristallographique que le premier germe, et on lui fait subir une rotation de 180° autour de l'axe (x). Le germe ainsi retourné, dit troisième germe, est disposé de manière jointive et contigüe au premier germe dans la direction (y) du quadrillage. De cette façon, les premier et troisième germes ainsi positionnés présentent des réseaux cristallins symétriques et une désorientation totale 2θ de 30°.

Enfin, pour finaliser le quadrillage, un quatrième germe est positionné. Pour cela, on sélectionne un germe du même lingot Cz qui présente la même orientation que le premier germe et on lui fait subir une rotation de 180° autour de l'axe (y) puis une rotation de 180° autour de l'axe (x). Le germe ainsi retourné, dit quatrième germe, est disposé de manière jointive et contigüe au deuxième germe dans la direction (y) du quadrillage. De cette façon, les deuxième et quatrième germes ainsi positionnés sont symétriques et présentent une désorientation totale 2θ de 30°.

*(ii) Croissance directionnelle du silicium par reprise sur germes*

Le four de cristallisation utilisé pour la cristallisation par reprise sur germes est un four possédant trois zones de chauffe pilotées en température ou en puissance : une zone de chauffe haute, une zone de chauffe basse et une zone de chauffe latérale.

Un lingot de silicium est formé dans le creuset par la succession des étapes suivantes :

- fusion dirigée de la charge de silicium et fusion partielle des germes ;
- croissance par solidification dirigée ; et
- refroidissement du lingot.

*Résultat*

Le lingot obtenu présente une hauteur de 20 cm. Il comporte des grains colonnaires, qui se sont développés perpendiculairement à la surface des germes selon l'axe Z du creuset. Ces grains sont séparés par des joints de grains qui se sont développés au cours de la solidification à partir des joints de germe, puis se sont propagés selon la direction Z, sur toute la hauteur du lingot.

Observés selon une direction normale à la surface supérieure du lingot, les joints de grains n'ont substantiellement pas dévié de la direction Z durant la solidification dirigée. La déviation d'un joint de grain observé en haut de lingot dans un plan horizontal est au plus de 4 mm.

Il est remarqué qu'à partir de l'intersection des joints de germes des quatre germes, dit jonction quadruple, se sont développées deux jonctions triples, la première jonction triple définissant une frontière entre les premier, deuxième et quatrième grains, la deuxième jonction triple définissant une frontière entre les premier, troisième et quatrième grains. Les jonctions triples, connues de l'homme du métier comme pouvant évoluer de façon instable au cours de la croissance d'un lingot de silicium, sont restées proches de la jonction quadruple dont elles sont issues, et ne s'en sont pas écartées. Elles ne génèrent pas non plus de déviation significative de la linéarité des joints de grains.

*(iii) Découpe du lingot*

Le lingot obtenu peut ensuite être découpé en briques dans un « *squarer* » avec un pas de guide-fils de 157,3 mm. Les plaquettes découpées dans de telles briques sont exemptes de joints de grains issus des joints de germes.

## EXEMPLE 3

Un pavage de type G5 comportant 36 germes de 25 mm d'épaisseur est préparé selon la méthode décrite au point (i) de l'exemple 1. Ce pavage comporte 25 germes de dimensions 144 mm x 144 mm formant un quadrillage carré de germes, 10 germes de dimensions 144 mm x 65 mm et 1 germe de dimensions 65 mm x 65 mm. Les germes constituant le pavage sont ainsi tels que deux germes contigus du pavage présentent une désorientation totale 2θ de 30°.

Le four de cristallisation utilisé pour la cristallisation par reprise sur germes est un four possédant trois zones de chauffe pilotées en température ou en puissance : une zone de chauffe haute, une zone de chauffe basse et une zone de chauffe latérale. La procédure de solidification dirigée est effectuée selon les étapes décrites pour l'exemple 2.

*Résultat*

Un lingot d'une hauteur de 275 mm et de section carré de 840 x 840 mm$^2$ est ainsi obtenu. Il présente des joints de grains symétriques séparant des grains de forme colonnaire d'axe Z.

Des plaquettes sont découpées à partir de ce lingot et présentent des dimensions 156 mm x 156 mm de façon à comporter au moins un joint de grain. De cette manière, en découpant le lingot à différentes hauteurs, il est possible de mesurer la position d'un joint de grain spécifique issu d'un joint de germe à différentes hauteurs du lingot.

Ainsi, des plaquettes comportant quatre grains dont les joints de grain se réunissent en une jonction quadruple ont été extraites à différentes hauteurs du lingot. L'observation de ces plaquettes confirme une position sensiblement constante de la jonction quadruple et des quatre joints de grains sur la hauteur du lingot. Les joints de grains sont donc sensiblement verticaux à travers l'épaisseur du lingot.

Par ailleurs, comme cela peut être observé sur la figure 8 qui représente une figure de pôle (001) d'une plaquette comportant quatre grains, les relations de symétrie cristalline entre les grains contigus sont respectées et conservées à mi-hauteur du lingot.

La figure de pôle de la figure 8 a été obtenue grâce à 9 cartographies EBSD établies chacune sur une zone de mesure d'une taille de 1,8 mm x 1,8 mm. Les zones de mesures sont choisies de façon à englober la jonction quadruple où se joignent les quatre joints de grain de la plaquette.

Sur une telle figure de pôle, on observe les positions des différentes normales aux plans (100) de la maille cubique élémentaire du cristal de silicium formant la plaquette, dans un repère lié au dispositif de mesure. Sur la figure 8, les axes (TD) et (RD) correspondent à des directions de mesure perpendiculaires l'une à l'autre et situées dans le plan la plaquette. La direction selon l'épaisseur de la plaquette (direction (ND)) correspond à l'axe normal à la figure de pôle passant par le centre de cette figure.

Ainsi, sur cette figure de pôle, les quatre grains de la plaquette présentent une direction <100> selon l'épaisseur de la plaque. En outre, les joints grain sont positionnés angulairement selon un angle de 40° autour de la direction (ND) dans le sens horaire par rapport aux axes de mesures (TD; RD).

Il est ainsi possible de vérifier que deux joints contigus présentent chacun une désorientation de 15° par rapport au joint de grain qui les sépare et que la désorientation cristalline entre les deux joints de grain contigus est égale à 30°.

**Revendications**

1. Procédé de fabrication d'un lingot de silicium (5), doté de joints de grains (6) symétriques, comprenant au moins les étapes consistant en :

   (i) disposer d'un creuset (1) d'axe (Z) longitudinal, dont le fond comporte un pavage formé de germes (2) de silicium monocristallin de forme pavé droit à base carrée ou rectangulaire et disposés de manière jointive, ledit pavage vu selon l'axe (Z) étant sous la forme d'un quadrillage de directions orthogonales (x) et (y) parallèles aux arrêtes des germes ; et
   (ii) procéder à la solidification dirigée de silicium par reprise sur germes selon une direction de croissance colinéaire à l'axe (Z) ;

   **caractérisé en ce que** le pavage en étape (i) est réalisé à partir de germes de silicium identiques, avec deux germes contigus suivant la direction (x) étant images l'un de l'autre par un retournement d'axe (y) et deux germes contigus selon la direction (y) étant images l'un de l'autre par un retournement d'axe (x) et la désorientation 2θ entre les réseaux cristallins de deux germes contigus étant supérieure à 4°.

2. Procédé selon la revendication 1, l'épaisseur (e) des germes (2) suivant l'axe (Z) étant supérieure ou égale à 5 mm.

3. Procédé selon la revendication 1 ou 2, la désorientation 2θ entre les réseaux cristallins de deux germes contigus étant supérieure ou égale à 5° et plus particulièrement comprise entre 6° et 45°.

4. Procédé selon l'une quelconque des revendications précédentes, le réseau cristallin d'un germe présentant une direction, en particulier une direction <100>, colinéaire à l'axe (Z).

5. Procédé selon l'une quelconque des revendications précédentes, les germes (2) étant issus d'un lingot élaboré selon une technique de tirage de Czochralski (10) de silicium ; ou du recyclage d'un lingot formé selon le procédé tel que revendiqué en revendication 1, en particulier par prélèvement partiel ou total d'une tranche horizontale, ou par prélèvement partiel d'une tranche verticale.

**6.** Lingot de silicium (5) doté de joints de grains (6) symétriques, obtenu selon le procédé de l'une quelconque des revendications 1 à 5.

**7.** Lingot selon la revendication 6, présentant une hauteur mesurée suivant l'axe (Z) de croissance supérieure ou égale à 100 mm, en particulier allant de 180 à 800 mm.

**8.** Procédé de fabrication de plaquettes de silicium monocristallin et dénué de joints de grains, comprenant une étape (iii) de découpe d'un lingot (5) de silicium tel que défini selon la revendication 6 ou 7, en briques, par découpe le long des plans P, un plan P étant défini par la frontière entre deux germes contigus du pavage de germes.

**9.** Procédé selon la revendication précédente, la découpe étant effectuée à l'aide d'un fil de découpe (8) ou d'une scie à bande.


**Patentansprüche**

**1.** Verfahren zur Herstellung eines Siliciumblocks (5) mit symmetrischen Korngrenzen (6), das zumindest folgende Schritte umfasst:

(i) Bereitstellen eines Tiegels (1) mit der Längsachse (Z), dessen Boden eine Parkettierung aufweist, die aus einkristallinen Siliciumkeimen (2) in Form gerader Kacheln mit quadratischer oder rechteckiger Grundfläche gebildet ist, die verbunden angeordnet sind, wobei die Parkettierung entlang der Achse (Z) betrachtet die Form eines Rasters der senkrecht zueinander verlaufenden Richtungen (x) und (y) parallel zu den Ecken der Keime aufweist; und
(ii) Durchführen der gerichteten Erstarrung von Silicium mittels Wachstum auf Keimen in einer Wachstumsrichtung, die kollinear zur Achse (Z) verläuft;

**dadurch gekennzeichnet, dass** die Parkettierung in Schritt (i) aus identischen Siliciumkeimen gebildet ist, wobei zwei benachbarte Keime in Richtung (x) durch Drehen um die Achse (y) spiegelbildlich zueinander sind und zwei benachbarte Keime in Richtung (y) durch Drehen um die Achse (x) spiegelbildlich zueinander sind und die Desorientierung 2θ zwischen den Kristallgittern von zwei benachbarten Keimen über 4° beträgt.

**2.** Verfahren nach Anspruch 1, wobei die Dicke (e) der Keime (2) entlang der Achse (Z) größer gleich 5 mm ist.

**3.** Verfahren nach Anspruch 1 oder 2, wobei die Desorientierung 2θ zwischen den Kristallgittern von zwei benachbarten Keimen größer gleich 5° beträgt und insbesondere zwischen 6° und 45° liegt.

**4.** Verfahren nach einem der vorhergehenden Ansprüche, wobei das Kristallgitter eines Keims eine Richtung, insbesondere eine Richtung <100> aufweist, die kollinear zur Achse (Z) ist.

**5.** Verfahren nach einem der vorhergehenden Ansprüche, wobei die Keime (2) aus einem Silicium-Block (10) stammen, der nach einem Czochralski-Ziehverfahren gefertigt wird; oder vom Recycling eines Blocks, der gemäß dem Verfahren nach Anspruch 1 hergestellt wird, insbesondere durch teilweises oder vollständiges Abschneiden einer waagerechten Scheibe oder durch teilweises Abschneiden einer senkrechten Scheibe.

**6.** Siliciumblock (5) mit symmetrischen Korngrenzen (6), der nach dem Verfahren nach einem der Ansprüche 1 bis 5 erhalten ist.

**7.** Block nach Anspruch 6, der eine entlang der Wachstumsachse (Z) gemessene Höhe von größer gleich 100 mm, insbesondere von 180 bis 800 mm aufweist.

**8.** Verfahren zur Herstellung von einkristallinen Siliciumplatten ohne Korngrenzen, das einen Schritt (iii) zum Schneiden von Bricks aus einem Siliciumblock (5) nach Anspruch 6 oder 7 mittels Schneiden entlang von Ebenen P umfasst, wobei eine Ebene P durch die Grenze zwischen zwei benachbarten Keimen der Keimparkettierung definiert ist.

**9.** Verfahren nach dem vorhergehenden Anspruch, wobei das Schneiden mithilfe eines Schneiddrahts (8) oder einer Bandsäge erfolgt.

**Claims**

1. Process for manufacturing a silicon ingot (5), provided with symmetrical grain boundaries (6), comprising at least the steps consisting of:

   (i) providing a crucible (1) of longitudinal axis (Z), the bottom of which comprises a tiling formed from monocrystalline silicon seeds (2) of square- or rectangular-based straight block shape and that are positioned contiguously, said tiling seen along the axis (Z) being in the form of a grid having orthogonal directions (x) and (y) parallel to the edges of the seeds; and
   (ii) carrying out the directional solidification of silicon by seeded regrowth in a growth direction collinear to the axis (Z); **characterized in that** the tiling in step (i) is produced from identical silicon seeds, with two adjacent seeds along the direction (x) being images of one another by a turning over in axis (y) and two adjacent seeds along the direction (y) being images of one another by a turning over in axis (x), and the disorientation 2θ between the crystal lattices of two adjacent seeds being greater than 4°.

2. Process according to Claim 1, the thickness (e) of the seeds (2) along the axis (Z) being greater than or equal to 5 mm.

3. Process according to Claim 1 or 2, the disorientation 2θ between the crystal lattices of two adjacent seeds being greater than or equal to 5° and more particularly between 6° and 45°.

4. Process according to any one of the preceding claims, the crystal lattice of a seed having a direction, in particular a <100> direction, collinear to the axis (Z).

5. Process according to any one of the preceding claims, the seeds (2) being derived from a silicon ingot (10) produced according to a Czochralski pulling technique; or from the recycling of an ingot formed according to the process according to claim 1, in particular by partial or complete removal of a horizontal slice, or by partial removal of a vertical slice.

6. Silicon ingot (5) provided with symmetrical grain boundaries (6), obtained according to the process of any one of Claims 1 to 5.

7. Ingot according to Claim 6, having a height measured along the growth axis (Z) of greater than or equal to 100 mm, in particular ranging from 180 to 800 mm.

8. Process for manufacturing monocrystalline silicon wafers that are free of grain boundaries, comprising a step (iii) of cutting a silicon ingot (5) as defined according to Claim 6 or 7, into bricks, by cutting along the planes P, a plane P being defined by the boundary between two adjacent seeds of the filing of seeds.

9. The process according to the preceding claim, the cutting being carried out using a cutting wire (8) or a bandsaw.

Fig. 1a

Fig. 1b

Fig. 1c

Fig. 1

Fig. 2

Fig. 3

Fig. 4

Fig. 5

Fig. 6a

Fig. 6b                     Fig. 6

## Fig. 7

## Fig. 8

## RÉFÉRENCES CITÉES DANS LA DESCRIPTION

**Documents brevets cités dans la description**

- WO 2007084934 A
- US 20100192838 A
- US 20100193989 A
- US 20100193664 A
- WO 2009014963 A
- US 20100197070 A
- US 20130095028 A
- DE 102011086669 A1

**Littérature non-brevet citée dans la description**

- **FUJIWARA et al.** Growth of structure-controlled polycrystalline silicon ingots for solar cells by casting. *Acta Materialia,* 2006, vol. 54, 3191-3197